# EUROPEAN PATENT SPECIFICATION

(11) **EP 3 278 370 B1**
(45) Date of publication and mention of the grant of the patent: **29.07.2020**
(21) Application number: 16711849.6
(22) Date of filing: 25.03.2016
(51) Int. Cl.: H01L 31/05, H01L 31/048

(54) **ELECTRICALLY CONTACTING AND INTERCONNECTING PHOTOVOLTAIC CELLS**
ELEKTRISCHE KONTAKTIERUNG UND VERBINDUNG VON PHOTOVOLTAIKZELLEN
CELLULES PHOTOVOLTAÏQUES DE MISE EN CONTACT ET D'INTERCONNEXION ÉLECTRIQUE

(30) Priority: 30.03.2015 EP 15161636
(43) Date of publication of application: 07.02.2018
(73) Proprietor: IMEC VZW, 3001 Leuven (BE)
(72) Inventor: BORGERS, Tom, 3001 Leuven (BE); SZLUFCIK, Jozef, 3001 Leuven (BE)
(74) Representative: DenK iP
(86) International application number: PCT/EP2016/056739
(87) International publication number: WO 2016/156276

(56) References cited:
- EP-B1- 1 547 158
- EP-B1- 2 660 878
- WO-A1-2014/095991
- CN-A- 104 347 746
- CN-B- 102 751 342
- US-A1- 2004 244 193
- US-B1- 8 951 824

## Description

### Field of the invention

The present invention relates to the field of photovoltaic cells, e.g. to methods for electrically contacting a photovoltaic cell, e.g. to interconnect a plurality of such photovoltaic cells. More in particular, the present invention is related to methods for electrically contacting a photovoltaic cell, e.g. a busbar-free photovoltaic cell, and to methods for electrically interconnecting such photovoltaic cells, e.g. busbar-free photovoltaic cells.

### Background of the invention

In typical commercially available photovoltaic cells, an electrical current generated under illumination is collected at metal fingers that are electrically connected to a few, e.g. typically three, wide busbars. Tinned copper strips or ribbons, which may also be referred to as connectors or interconnectors, may be soldered to the busbars to electrically connect photovoltaic cells within a module in a photovoltaic cell system as known in the art, e.g. to connect photovoltaic cells in series or in parallel. The size of the interconnectors is preferably limited to avoid excessive shadowing on the illuminated surface of the cells.

Furthermore, methods are known in the art for contacting and interconnecting busbar-free photovoltaic cells. In such methods, the metal fingers of the busbar-free photovoltaic cells are contacted and connected by means of multiple electrically conductive wires. These electrically conductive wires may thus replace the busbars and the interconnectors. It is an advantage of such methods that a lower cost of photovoltaic modules can be achieved, e.g. due to a reduced silver consumption for the metallization and/or due to an increased module efficiency resulting from a lower series resistance and improved light harvesting.

The wires for contacting the busbar-free photovoltaic cells may, for example, be solder-coated copper wires. The wires may furthermore be soldered onto the cells before encapsulation, e.g. as described in "Multi-wire interconnection of busbar-free solar cells", Johann Walter et al, Energy Procedia 55(2014) 380-388. In this approach, the wires may be preferably soldered to solder pads provided on the metal fingers of the cell. However, such prior-art methods may have the disadvantages of requiring a carefully controlled wire expansion during the soldering process, a risk of wire displacement from the solder pads during soldering and a need for a high positioning accuracy.

EP2660878 describes the use of hybrid woven material of conductive wires interwoven with insulating wires in back-contacts of solar cells. WO2014/095991 describes a device for interconnecting photovoltaic cells having contacts on their back side, wherein the device has a layer of a woven produced from electrically insulating fibres. CN104347746 describes a main-grid-free, high-efficiency back contact solar battery module and a corresponding back contact solar battery assembly as well as a corresponding preparation process.

In EP1547158, a method is described in which busbar-free photovoltaic cells are contacted and interconnected by means of an electrode comprising an electrically insulating optically transparent film, an adhesive layer on one surface of the film and a plurality of substantially parallel, electrically conductive wires embedded into the adhesive layer, a part of the surfaces of the wires protruding from the adhesive layer. The electrically conductive wires are covered by a coating consisting of an alloy with a low melting point. The technology is based on applying the foil directly onto the metallized cell and performing a pressing and heating process, thereby bonding the wires to the metal fingers of the photovoltaic cell and providing an electrical contact between the wires and the metal fingers. It is an advantage that the temperature during the connection process can be kept low, resulting in a reduced stress on the cells. However, a disadvantage of this approach is that the wires attached to the film are only contactable at one side of the film. Therefore a terminal bar needs to be provided at the end of the wires to enable interconnection of cells. Another disadvantage is that differences in thermal expansion between the cells and the wires may generate mechanical stress in the system.

### Summary of the invention

It is an object of embodiments of the present invention to provide good and efficient electrical contacts and interconnections in photovoltaic cell systems, e.g. for busbar-free photovoltaic cells, e.g. silicon photovoltaic cells.

The above objective is accomplished by a method and device according to the present invention.

It is an advantage of embodiments of the present invention that a high contacting flexibility is provided in a photovoltaic cell system, e.g. a higher contacting flexibility as compared to known methods.

It is an advantage of embodiments of the present invention that photovoltaic cells, e.g. busbar-free photovoltaic cells, e.g. silicon photovoltaic cells, can be interconnected without the need for providing terminal bars or end ribbons.

It is an advantage of embodiments of the present invention that electrical contacts and/or interconnections for photovoltaic cells are provided while simultaneously providing a good encapsulation of the photovoltaic cells in an easy and efficient manner.

It is an advantage of embodiments of the present invention that differences in thermal expansion between the photovoltaic cells and interconnecting wires are relieved.

The present invention relates to a method for electrically contacting photovoltaic cells, e.g. busbar-free photovoltaic cells. A method of the present disclosure comprises providing a woven fabric that comprises a plurality of electrically conductive wires, the electrically conductive wires being provided in a single one of a warp direction and a weft direction. The woven fabric further comprises a plurality of polymer yarns, the polymer yarns being provided in at least the other one of the warp direction and the weft direction. For example, the electrically conductive wires may be provided in the weft direction and the polymer yarns may be provided in the warp direction. For example, the electrically conductive wires may be provided in the warp direction and the polymer yarns may be provided in the weft direction. For example, the electrically conductive wires may be provided in either one of the weft direction and the warp direction and the polymer yarns may be provided in both the weft direction and the warp direction.

The method further comprises bringing the woven fabric into physical contact with a surface of a photovoltaic cell comprising a plurality of metal contacts, and performing a heating process, thereby establishing an electrical connection between the respective metal contacts and at least one electrically conductive wire and thereby liquefying, e.g. melting, the plurality of polymer yarns such as to transform the plurality of polymer yarns into an encapsulation layer.

In a method in accordance with embodiments of the present invention, the plurality of metal contacts may for example comprise, e.g. consist of, a plurality of parallel metal lines, e.g. metal fingers, having a longitudinal direction. In such embodiments, bringing the woven fabric into physical contact with the surface of the photovoltaic cell comprises orienting the woven fabric such that the electrically conductive wires are in a direction other than the longitudinal direction of the parallel metal lines, e.g. substantially orthogonal to the longitudinal direction of the parallel metal lines.

In a method in accordance with embodiments of the present invention, the plurality of metal contacts may for example comprise, e.g. be composed of, metal features extending in different non-parallel, i.e. intersecting, directions. It is an advantage of such embodiments that any orientation of the woven fabric with respect to the photovoltaic cell may be used.

In a method in accordance with embodiments of the present invention, the woven fabric may be preferably a twill weave fabric. It is an advantage of using a twill weave fabric that the plurality of electrically conductive wires is exposed at the surfaces of the fabric over a length, also referred to as 'float', between two consecutive intersections with the fabric that bridges several polymer yarns. The float can be made sufficiently large to allow a good and reliable electrical connection of the metal wires to the metal contacts of the photovoltaic cell.

In a method in accordance with embodiments of the present invention, the provided polymer yarns may comprise, e.g. consist of, polymer ribbons.

In a method in accordance with embodiments of the present invention, the polymer ribbons may be provided in the warp direction, e.g. exclusively in the warp direction, and the electrically conductive wires may be provided in the weft direction, e.g. exclusively in the weft direction.

In a method in accordance with embodiments of the present invention, performing the heating process may comprise performing a first heating step at a first temperature and afterwards performing a second heating step at a second temperature, the second temperature being higher than the first temperature. The first temperature may be selected to enable soldering of the plurality of metal wires to the metal contacts of the photovoltaic cell. The second temperature may be selected to enable melting of the polymer yarns. For example, the first temperature may be in the range between 120°C and 240°C and the second temperature may be 10°C to 50°C higher than the first temperature, embodiments of the present invention not being limited thereto. It is an advantage of using a two-step heating process that the first heating step corresponding to the soldering may be performed at a first temperature that is lower than the melting temperature of the polymer wires. Therefore, during soldering, the polymer material is not yet liquefied, such that the risk of penetration of polymer material between the metal contacts and the metal wires, which would lead to bad contacts, can be avoided.

In accordance with embodiments of the present invention, the polymer yarns forming the encapsulation layer may be preferably made of a material that is transparent to light, such as for example a polyolefin material. The material of the polymer yarns may have a transparency higher than 95%, preferably higher than 98%, e.g. at least 99%, for light in the wavelength range between 350 nm and 1000 nm, preferably for light in the wavelength range between 240 nm and 1200 nm.

In accordance with embodiments of the present invention, the electrically conductive wires may be preferably metal wires coated with a solder material, e.g. a solder alloy. The electrically conductive wires may be preferably spread, e.g. substantially evenly spread, over the woven fabric, e.g. at least in an area of physical contact between the woven fabric and the surface of the photovoltaic cell.

In accordance with embodiments of the present invention, the solder material may have preferably a melting temperature that is lower than the melting temperature of the plurality of polymer yarns.

The present invention further relates to a method for electrically connecting photovoltaic cells, e.g. silicon photovoltaic cells, and to a method for fabricating photovoltaic modules.

A method for electrically connecting a first photovoltaic cell with a second photovoltaic cell in accordance with embodiments of the present invention comprises providing a woven fabric comprising a plurality of electrically conductive wires, the electrically conductive wires being provided in a single one of a warp direction and a weft direction, the woven fabric further comprising a plurality of polymer yarns, the polymer yarns being provided in at least the other one of the warp direction and the weft direction. This method further comprises bringing a first part of the woven fabric into physical contact with a surface of the first photovoltaic cell comprising first metal contacts, and bringing a second part of the woven fabric into physical contact with a surface of the second photovoltaic cell comprising second metal contacts. This method also comprises performing a heating process, thereby establishing an electrical connection between the respective first metal contacts and at least one electrically conductive wire and between the respective second metal contacts and at least one electrically conductive wire, at least one electrically conductive wire being electrically connected to both a first metal contact and a second metal contact, and thereby liquefying the plurality of polymer yarns and transforming them into an encapsulation layer.

Preferably, more than one electrically conductive wire may be electrically connected to both a first metal contact and a second contact. A plurality of electrically conductive wires may be electrically connected to both a first metal contact and a second contact, for example each electrically conductive wire may be electrically connected to both a first metal contact and a second metal contact.

The surface of the first photovoltaic cell that comprises first metal contacts may for example be a front surface of the first cell, and the surface of the second photovoltaic cell that comprises second metal contacts may for example be a rear surface of the second cell. In such method according to embodiments of the present invention, an electrical series connection may be established between the first photovoltaic cell and the second photovoltaic cell.

In a method in accordance with embodiments of the present invention, the first part may be brought into contact with this first photovoltaic cell on a first side of the woven fabric, the second part may be brought into contact with the second photovoltaic cell on a second side of the woven fabric, in which the first and second side are opposite sides of the woven fabric.

In a method in accordance with embodiments of the present invention, the single woven fabric may be a twill weave fabric. The first part may have an uneven warp-face twill weave, and the second part may have an uneven weft-face twill weave.

A method in accordance with embodiments of the present invention may further comprise providing at least one diode in a border region of the woven fabric. One terminal of the at least one diode may be connected to the electrically conductive wires, e.g. to at least one of the electrically conductive wires, e.g. to all of the electrically conductive wires. Another terminal of the at least one diode may be adapted for connecting to at least one further photovoltaic cell.

In a method in accordance with embodiments of the present invention, the first photovoltaic cell and the second photovoltaic cell may be connected such as to form at least a part of a first cell string.

In a method in accordance with embodiments of the present invention, the at least one further photovoltaic cell may form at least a part of a second cell string, and the at least one diode may be a bypass diode for connecting the first cell string to said the second cell string.

A method for fabricating a photovoltaic module in accordance with embodiments of the present invention may comprise electrically connecting a plurality of photovoltaic cells using a method as described hereinabove.

In a further aspect, embodiments of the present invention relate to a photovoltaic module comprising at least two photovoltaic cells, e.g. a plurality of photovoltaic cells, the at least two photovoltaic cells, e.g. the plurality of photovoltaic cells, being electrically contacted and electrically connected by means of a plurality of electrically conductive wires, wherein the photovoltaic module is free of terminal bars and free of end ribbons.

The at least two photovoltaic cells, e.g. the plurality of photovoltaic cells, may be busbar-free photovoltaic cells. The at least two photovoltaic cells may for example be electrically connected in series, embodiments of the present invention not being limited thereto.

It is an advantage of methods according to embodiments of the present invention that the electrically conductive wires may be exposed at both opposite sides or opposite surfaces of the woven fabric. Therefore the woven fabric can be electrically contacted at both surfaces of the fabric. This offers a high flexibility of contacting and interconnection of photovoltaic cells, such as for example series connection of photovoltaic cells.

It is an advantage of methods according to embodiments of the present invention that the woven fabric comprises an encapsulation material. Therefore process steps for contacting and interconnecting the photovoltaic cells and process steps for encapsulating the photovoltaic cells or the photovoltaic module may be combined in a single process.

It is an advantage of methods according to embodiments of the present invention that the electrically conductive wires used for contacting and interconnecting the photovoltaic cells are provided in a 'wave' pattern, e.g. as a consequence of the electrically conductive wires being woven into the woven fabric. When the contacted and/or interconnected photovoltaic cells are subject to changes in temperature, such wave pattern can advantageously offer a stress relief.

It is an advantage of methods according to embodiments of the present invention that photovoltaic cells and/or photovoltaic modules may be provided with an improved optical yield. Such improved optical yield may result from light reflection at the electrically conductive wires towards the photovoltaic cells. Due to the wave pattern of the electrically conductive wires, the wires can be locally spaced apart from the cell surface, resulting in a reduced shadowing effect.

It is an advantage of methods in accordance with embodiments of the present invention that bifacial photovoltaic cells can be interconnected by such method.

It is an advantage of methods according to embodiments of the present invention that there is no need for providing a terminal bar at the end of the wires to enable interconnection of cells. A method of the present disclosure can therefore advantageously be used for fabricating transparent photovoltaic modules, i.e. photovoltaic modules with a spacing between the interconnected cells, such as for example for building integrated applications. Using a method according to embodiments of the present invention, the areas between the interconnected cells can be made transparent, without terminal bars between the cells.

It is an advantage of methods in accordance with embodiments of the present invention that the woven fabric can have a uniform thickness, e.g. the presence of the electrically conductive wires does not add a topography to the fabric. Therefore the amount of encapsulation material, e.g. comprising or corresponding to the polymer wires in a method according to embodiments of the present invention, may be reduced as compared to known methods, e.g. because there is no need for levelling off a variation in topography or a thickness or height difference.

Certain objects and advantages of various inventive aspects have been described herein above. Of course, it is to be understood that not necessarily all such objects or advantages may be achieved in accordance with any particular embodiment of the present invention. Thus, for example, those skilled in the art will recognize that the invention may be embodied or carried out in a manner that achieves or optimizes one advantage or group of advantages as taught herein without necessarily achieving other objects or advantages as may be taught or suggested herein.

Particular and preferred aspects of the invention are set out in the accompanying independent and dependent claims. Features from the dependent claims may be combined with features of the independent claims and with features of other dependent claims as appropriate and not merely as explicitly set out in the claims.

These and other aspects of the invention will be apparent from and elucidated with reference to the embodiment(s) described hereinafter.

### Brief description of the drawings

FIG 1 shows an example of a twill weave fabric that may be used in a method in accordance with embodiments of the present invention.
FIG 2 shows an example of a metal contact pattern of a busbar-free photovoltaic cell, that may be used in a method in accordance with embodiments of the present invention, in which the contact pattern comprises parallel, digitated contacts.
FIG 3 shows an example of a metal contact pattern of a busbar-free photovoltaic cell, that may be used in a method in accordance with embodiments of the present invention, in which the contact pattern comprises parallel, digitated contacts in a diagonal orientation.
FIG 4 shows an example of a metal contact pattern of a busbar-free photovoltaic cell, that may be used in a method in accordance with embodiments of the present invention, in which the contact pattern comprises contact features oriented in different directions.
FIG 5 illustrates a step of bringing a twill fabric in contact with a surface of a photovoltaic cell in a method in accordance with embodiments of the present invention.
FIG 6 shows exemplary locations of contact areas between electrically conductive wires integrated in a twill fabric and metal contacts of an underlying photovoltaic cell, in accordance with embodiments of the present invention.
FIG 7 illustrates a method for electrically connecting a first photovoltaic cell with a second photovoltaic cell according to embodiments of the present invention.
FIG 8 illustrates a first process step of an exemplary method for fabricating a photovoltaic module, wherein photovoltaic cells are electrically connected according to a method in accordance with embodiments of the present invention.
FIG 9 illustrates a second process step of an exemplary method for fabricating a photovoltaic module, in accordance with embodiments of the present invention.
FIG 10 illustrates a third process step of an exemplary method for fabricating a photovoltaic module, in accordance with embodiments of the present invention.
FIG 11 illustrates a fourth process step of an exemplary method for fabricating a photovoltaic module, in accordance with embodiments of the present invention.
FIG 12 illustrates a fifth process step of an exemplary method for fabricating a photovoltaic module, in accordance with embodiments of the present invention.
FIG 13 illustrates a sixth process step of an exemplary method for fabricating a photovoltaic module, in accordance with embodiments of the present invention.
FIG 14 illustrates a seventh process step of an exemplary method for fabricating a photovoltaic module, in accordance with embodiments of the present invention.
FIG 15 illustrates an eighth process step of an exemplary method for fabricating a photovoltaic module, in accordance with embodiments of the present invention.
FIG 16 illustrates methods in accordance with embodiments of the present invention, in which polymer ribbons are provided, e.g. woven, in a warp direction and electrically conductive wires are provided, e.g. woven, in a weft direction of a woven fabric.
FIG 17 illustrates exemplary methods in accordance with embodiments of the present invention, in which the woven fabric is provided as a twill fabric having an uneven weave.
FIG 18 illustrates an exemplary method in accordance with embodiments of the present invention, in which bifacial photovoltaic cells are interconnected using a twill-woven fabric having an uneven weave, this weave being a different weave in two regions contacting the different photovoltaic cells.
FIG 19 illustrates a method in accordance with embodiments of the present invention, in which diodes, e.g. bypass diodes, are provided.

Any reference signs in the claims shall not be construed as limiting the scope of the present invention.

In the different drawings, the same reference signs refer to the same or analogous elements. The drawings are only schematic and are non-limiting. In the drawings, the size of some of the elements may be exaggerated and not drawn on scale for illustrative purposes.

### Detailed description of illustrative embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not necessarily correspond to actual reductions to practice of the invention.

Furthermore, the terms first, second, third and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the present invention can operate in other sequences than described or illustrated herein.

Moreover, the terms top, bottom, over, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

The term "comprising", used in the claims, should not be interpreted as being restricted to the means listed thereafter; it does not exclude other elements or steps. It needs to be interpreted as specifying the presence of the stated features, integers, steps or components as referred to, but does not preclude the presence or addition of one or more other features, integers, steps or components, or groups thereof. Thus, the scope of the expression "a device comprising components A and B" should not be limited to devices consisting only of components A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

In the following detailed description, numerous specific details are set forth in order to provide a thorough understanding of the invention and how it may be practiced in particular embodiments. However, it will be understood that embodiments of the present invention may be practiced without these specific details. In other instances, well-known methods, procedures and techniques have not been described in detail, so as not to obscure an understanding of the present description.

In the context of embodiments of the present invention, the front surface or front side of a photovoltaic cell or of a photovoltaic module refers to the surface or side adapted for being oriented towards a light source and thus for receiving illumination. However, in case of bifacial photovoltaic cells or modules, both surfaces are adapted to receive impinging light. In such case, the front surface or front side is the surface or side adapted for receiving the largest fraction of the light or illumination. The back surface, rear surface, back side or rear side of a photovoltaic cell or a photovoltaic module is the surface or side opposite to the front surface or side.

In the context of embodiments of the present invention, a busbar refers to an electrically conductive strip for collecting an electrical current, e.g. a current generated under illumination, from a plurality of metal contacts provided on a surface of a photovoltaic cell. A busbar is provided for direct electrical connection with an external electrical lead. A busbar typically collects the current from finer or narrower metal contacts, also called metal fingers, on the cell. These finer or narrower metal contacts collect current from the cell and deliver the current to the busbars; they are typically not provided for direct electrical connection to an external electrical lead.

In the context of embodiments of the present invention, a busbar-free photovoltaic cell is a photovoltaic cell not having busbars. A busbar-free photovoltaic cell may typically comprise a plurality of metal contacts on a surface of the cell, but it does not comprise an electrically conductive element for collecting current from the plurality of metal contacts.

In the context of embodiments of the present invention, a twill fabric or a twill weave is a weave wherein one or more weft yarns (or warp yarns) alternately pass over and under two or more warp yarns (or weft yarns respectively) in a regular repeated manner, with a step or offset between rows. Twill weave is a basic weave characterized by pronounced diagonal ridges, called twill lines. Where is referred to yarns in the context of embodiments of the present invention, reference is made to elongate elements suitable for forming a woven fabric by weaving. A yarn may have a homogeneous structure, e.g. obtained by extrusion, or a composite structure, e.g. by combining component filaments into a thread or strand. A yarn may be composed of a single material or a combination of materials. Particularly, a yarn may refer to a thread, a wire, a filament, a strand, a ribbon, a strip, a tubular structure or a similar elongate element suitable for being woven into a woven fabric.

The present invention relates to methods for electrically contacting a photovoltaic cell and/or for electrically interconnecting photovoltaic cells, e.g. busbar-free photovoltaic cells. Such methods according to embodiments of the present invention are generally based on the usage of a woven fabric, preferably a twill fabric, e.g. made of an optically transparent polymer material, with electrically conductive wires provided in, e.g. woven into, the fabric in a single direction, e.g. such that the electrically conductive wires are provided substantially parallel to each other. The fabric is brought into physical contact with a surface of a photovoltaic cell, e.g. a busbar-free photovoltaic cell, to which a contact is to be made and a heating process is performed. By performing the heating process, an electrical contact and/or electrical connection is established between the electrically conductive wires of the fabric and metal contacts of the photovoltaic cell. Furthermore, the polymer material is molten and transformed into an encapsulation layer of the photovoltaic cells by this heating process, such that the encapsulation layer embeds the electrically conductive wires.

A woven fabric provided in a method in accordance with embodiments of the present invention comprises a plurality of electrically conductive wires, the electrically conductive wires being provided in a single one of a warp direction and a weft direction. The woven fabric further comprises a plurality of polymer yarns, the polymer yarns being provided in at least the other one of the warp direction and the weft direction. For example, the electrically conductive wires may be provided in the weft direction and the polymer yarns may be provided in the warp direction. For example, the electrically conductive wires may be provided in the warp direction and the polymer yarns may be provided in the weft direction. For example, the electrically conductive wires may be provided in either one of the weft direction and the warp direction and the polymer yarns may be provided in both the weft direction and the warp direction.

A woven fabric provided in a method in accordance with embodiments of the present invention may thus comprise a plurality of polymer yarns provided in a warp direction and/or in a weft direction. The woven fabric further comprises a plurality of electrically conductive wires that are provided in a single one of the warp direction and the weft direction. The polymer yarns may be preferably made of a material that is optically transparent in a wavelength range that is absorbed by the photovoltaic cell, e.g. silicon photovoltaic cell. For example, the polymer material may have an optical transparency higher than 95%, preferably higher than 98%, e.g. at least 99%, for light in the wavelength range between 350 nm and 1000 nm, preferably for light in the wavelength range between 240 nm and 1200 nm, the present disclosure not being limited thereto. The material of the polymer yarns furthermore may have preferably a good UV stability, e.g. it preferably shows no degradation or no substantial degradation under UV illumination, e.g. a very limited or negligible degradation under UV illumination. For example, the polymer yarns may comprise, or may be composed of, a polyolefin material, a thermoplastic polyurethane (TPU) or a polyvinyl butyral (PVB), embodiments of the present invention not being limited thereto.

In embodiments according to the present invention, the polymer yarns may comprise, e.g. consist of, polymer wires. In embodiments according to the present invention, the polymer yarns may comprise, e.g. consist of, polymer ribbons. For example, such polymer ribbons may be obtained by cutting or slitting a polymer foil into ribbons, e.g. to obtain strips of the polymer foil. It is an advantage of such polymer ribbons that an easy, fast and efficient weaving can be performed, e.g. such that the weaving process can be carried out in a cost-effective manner. For example, a densely woven fabric can be provided in accordance with embodiments of the present invention, e.g. having a relatively high encapsulant mass per unit of fabric area for a relatively low ribbon count per unit of fabric length in the weft direction. For example, the width of such ribbons may be optimized to the photovoltaic cell to be electrically contacted, e.g. to the intended interconnection pattern for such cells.

The electrically conductive wires may for example be made of a metal, such as copper or another suitable metal having a high electrical conductivity, and they may be covered by a solder coating, such as for example by a coating (e.g. an alloy) comprising Sn, Bi, In, Cu and/or Ag, embodiments of the present invention not being limited thereto.

In a method in accordance with embodiments of the present invention, twill weave may be a preferred weave for providing the polymer yarns, e.g. polyolefin encapsulation yarns, and the electrically conductive wires, e.g. solder coated copper wires. The high density of wires per unit area of a twill weave advantageously allows the integration of a sufficiently large volume of polymer yarns, so that after the heating process a good encapsulation of the photovoltaic cells is obtained. It is an advantage that there may be no need for providing additional encapsulation material when using a method of the present disclosure. However, the skilled person will understand that additional encapsulation may be provided in accordance with embodiments of the present invention to even further improve the insulation of the cells, e.g. if a particular application requires a particularly high quality of encapsulation, e.g. to protect the cells from a harsh environment.

In a twill fabric as used in a method in accordance with embodiments of the present invention, the electrically conductive wires, e.g. each electrically conductive wire, may alternately pass over a first number of polymer yarns and under a second number of polymer yarns. In a method in accordance with embodiments of the present invention, the polymer yarns may be provided in a balanced twill fabric, in which this first number of polymer yarns equals this second number of polymer yarns. Thus, in embodiments of the present invention, a balanced twill fabric may advantageously be used, but embodiments of the present invention are not limited thereto. For example, as further described in more detail, in a method in accordance with embodiments of the present invention, an uneven twill fabric may be used, wherein the first number of polymer yarns over which an electrically conductive wire passes is different from the second number of polymer yarns under which the electrically conductive wire passes. Thus, in embodiments of the present invention, an uneven twill fabric may advantageously be used. In a twill fabric as used in a method in accordance with embodiments of the present invention, the electrically conductive wires, e.g. each electrically conductive wire, may be alternately exposed at a first surface of the fabric and at a second, opposite, surface of the fabric. It is an advantage that the electrically conductive wires in the fabric can thus be electrically contacted from either side of the fabric, e.g. the fabric is double-side contactable. By selecting the number of polymer weft yarns (or warp yarns) over and under which the electrically conductive wires alternately pass, e.g. by selecting the first number of polymer yarns and the second number of polymer yarns as described hereinabove, a length (also called 'float') of the electrically conductive wires on a surface of the fabric between two consecutive intersections with the fabric may be determined. In case of a balanced twill, the length of the exposed parts of the conductive wires may be substantially equal at both sides, i.e. at both surfaces, of the fabric. In case of an uneven twill fabric, the electrically conductive wires may protrude more prominently on one side of the fabric than on the other side of the fabric, such that the length of the exposed parts of the conductive wires may be different between both sides, i.e. between both surfaces, of the fabric.

The density of the conductive wires in the fabric, e.g. the average number of conductive wires per unit of length of fabric in a direction, in the plane of the fabric, that is perpendicular to the longitudinal orientation of the conductive wires, or the lateral distance between neighboring conductive wires in the fabric, and the twill line slope may be optimized and adapted to the metal contact pattern on the surface of the photovoltaic cell. The density of the conductive wires and the twill line slope have an influence on the length of the current path in the metal contacts of the cell towards the metal wires in the fabric and thus on resistive losses. Further, the density of the conductive wires, and their diameter, has an influence on shadowing losses. For example, in case the metal contact pattern of the photovoltaic cell consists of a plurality of parallel metal fingers, the density of conductive wires in the fabric may be optimized taking into account the finger spacing and finger resistance at one hand and shadowing losses at the other hand.

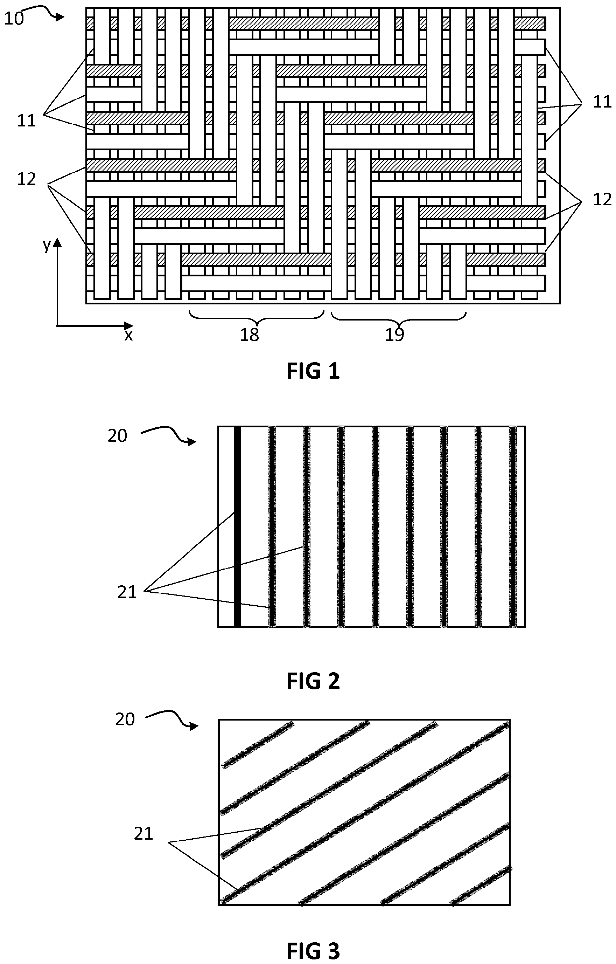

FIG 1 shows an example of (a part of) a woven fabric 10, more in particular an example of a twill fabric, that may be used in methods in accordance with embodiments of the present invention. The fabric 10 comprises a plurality of polymer yarns 11, which polymer yarns 11 may be provided in two different, substantially orthogonal directions, corresponding to the warp direction y and the weft direction x of the woven fabric 10. The polymer yarns may comprise, e.g. may be preferably made of, a material that is suitable as an encapsulation material for a photovoltaic cell or module. The polymer yarns may be preferably made of a material that is transparent, for example it may have transparency higher than 95%, preferably higher than 98%, e.g. at least 99%, for light in the wavelength range between 350 nm and 1000 nm, preferably for light in the wavelength range between 240 nm and 1200 nm, embodiments of the present invention not being limited thereto. For example, the polymer yarns may be made of a polyolefin material. The fabric 10 further comprises a plurality of electrically conductive wires 12 being provided in a single direction, e.g. substantially parallel to each other, e.g. in a single one of the warp direction y and the weft direction x of the fabric 10, which may be spread over the fabric, e.g. substantially evenly spread over the fabric. In the example shown in FIG 1, the electrically conductive wires 12, or yarns, alternately pass over and under six polymer yarns 11, with a step or offset of two yarns. This is only an example, and the present disclosure is not limited thereto. For example, the number of polymer yarns the conductive wires pass over and under may be different and/or the offset may be different.

The twill fabric 10 shown in FIG 1 is an example of a balanced twill fabric, wherein the number of yarns 18 over which another yarn passes equals the number of yarns 19 under which the yarn passes, in which 'yarn' may refer equally to the polymer yarns, the electrically conductive wires or a combination of both, e.g. as provided in respectively a warp or a weft direction in accordance with embodiments of the present invention. For such a balanced twill fabric 10, both opposite surfaces of the fabric may have the same appearance, and the length of the exposed part of the electrically conductive wires 12 may be substantially the same at both surfaces of the fabric 10.

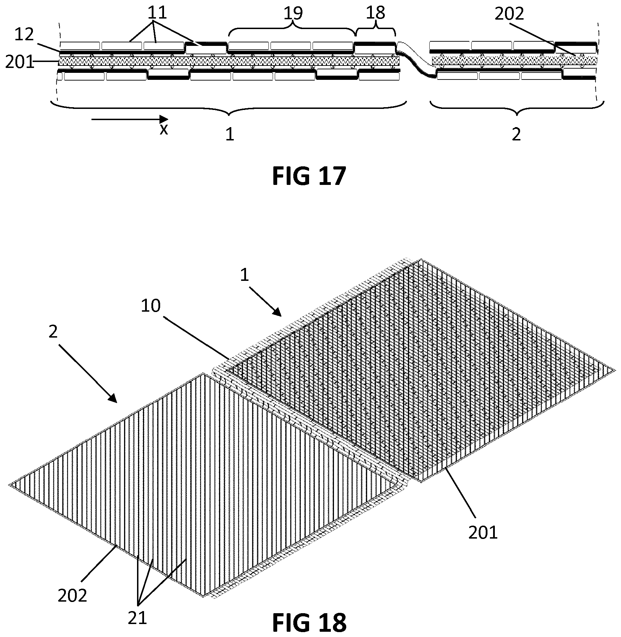

However, in a method in accordance with embodiments of the present invention, the twill fabric 10 may also be an uneven twill fabric. In a twill fabric having an uneven twill weave, warp (and/or weft) yarns may protrude more prominently on one side of the fabric than on the other side of the fabric. For example, FIG 17 illustrates an exemplary method for contacting a photovoltaic cell 201,202, in which the woven fabric 10 is provided as a twill fabric having an uneven weave. In this example, the number of polymer yarns 18 over which an electrically conductive wire 12 passes is not equal to the number of yarns 19 under which the electrically conductive wire 12 passes. Therefore, an uneven weave twill fabric, as used in accordance with embodiments of the present invention, may have more warp wires on one surface, referred to as the warp-face, resulting in more weft wires on the opposite side of the weave. The construction of a twill weave may be identified by a fraction, in which the numerator indicates the number of warp threads crossing over a number of weft threads as indicated in the denominator. For example, for an uneven 3/1 ratio twill, the warp wire may sequentially be crossing over three weft wires and under one weft wire, such that the largest part of the warp wire protrudes on the surface of the weave, e.g. as illustrated in FIG 17.

In a method in accordance with embodiments of the present invention, the polymer yarns may comprise polymer ribbons. It is an advantage of such embodiments that easier processing and a faster and more cost-effective weaving may be provided as compared to weaving of polymer wires, e.g. extruded polymer wires. A dense weave may thus be provided, with a low ribbon count per cm, e.g. enabling a fast and cost-effective weaving, and a high polymer mass per unit area of the fabric.

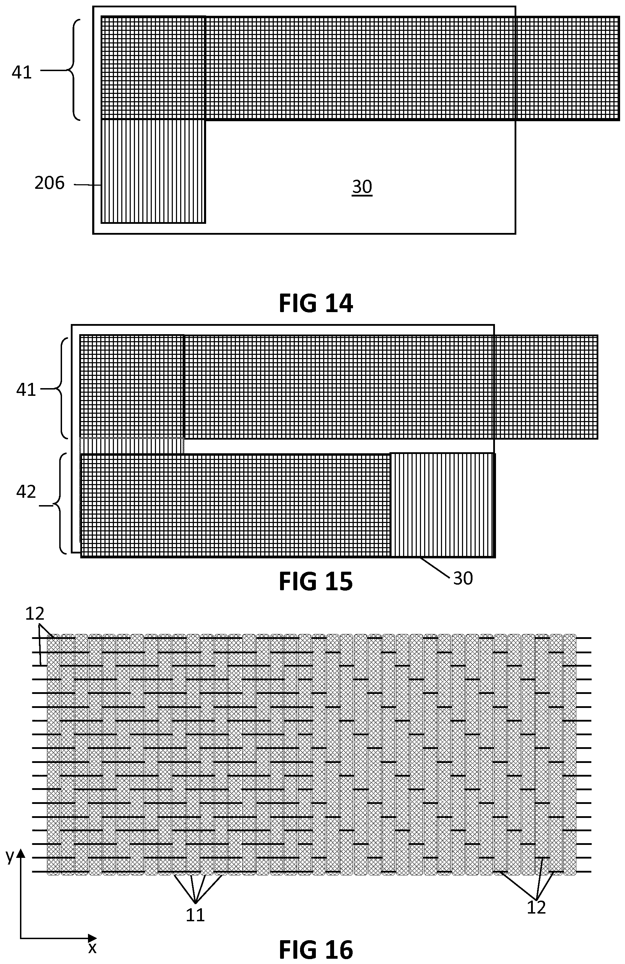

In a method in accordance with embodiments of the present invention, the polymer ribbons may be preferably provided in the warp direction y, e.g. exclusively in the warp direction y, and the electrically conductive wires 12 may be preferably provided in the weft direction x, e.g. exclusively in the weft direction x, as shown in FIG 16. For example, in other embodiments where the polymer yarns 11, e.g. polymer wires or polymer ribbons, are provided in both the warp and the weft direction, such as illustrated in FIG 1, the diameter of the electrically conductive wires 12 may be substantially determined by, e.g. constrained by, the thickness of the polymer yarns, e.g. to enable an efficient interweaving of the conductive wires in the woven fabric. However, in embodiments of the present invention, such as illustrated by FIG 16, the use of polymer ribbons in only the warp direction advantageously provides more freedom, e.g. by allowing an independent thickness variation, of the polymer ribbons and the electrically conductive wires 12. Furthermore, by having the conductive wires only oriented in the weft direction x, the distance between the wires, e.g. and thus the number of wires per cm, can be easily adapted according to needs, for example as function of the serial resistance in a photovoltaic module or the total cross-section of the wires and/or as function of the costs of the conductive wires used. In other embodiments of the present invention the polymer ribbons 11 may be provided exclusively in the weft direction and the electrically conductive wires 12 may be provided exclusively in the warp direction, but this may require more complex weaving technologies as compared to embodiments wherein the polymer ribbons are provided exclusively in the warp direction and the electrically conductive wires in the weft direction.

In a method in accordance with embodiments of the present invention, a fabric 10, e.g. as shown in FIG 1, is brought into physical contact with a surface of a photovoltaic cell, e.g. a busbar-free photovoltaic cell, that comprises a plurality of metal contacts to which an electrical connection is to be made. By doing this, preferably each respective metal contact of the photovoltaic cell may be brought into contact with at least one electrically conductive wire 12 of the fabric 10. In embodiments of the present invention, each respective metal contact of the photovoltaic cell may be in contact with more than one electrically conductive wire 12, e.g. with a plurality of electrically conductive wires 12. The weaving pattern, the wire size and the wire spacing may be optimized to allow a sufficient amount of connections with the metal contacts of the photovoltaic cell, e.g. an amount of connection that allows limiting resistive losses.

FIG 2, FIG 3 and FIG 4 show examples of metal contact patterns 21 of busbar-free photovoltaic cells 20, e.g. silicon photovoltaic cells, that may be used in embodiments of the present invention. The plurality of metal contacts 21 of a busbar-free photovoltaic cell 20 may for example consist of a plurality of fingers, i.e. a plurality of substantially parallel metal lines. The fingers 21 may extend from one edge of the photovoltaic cell 20 to an opposite edge of the cell as illustrated in FIG 2, but embodiments of the present invention are not limited thereto. In embodiments of the present invention, the fingers may, for example, comprise, e.g. be composed of, interrupted lines. In the example illustrated in FIG 2, the fingers 21 are provided in a direction substantially parallel to an edge of the photovoltaic cell 20. However, embodiments of the present invention are not limited thereto, and the fingers 21 may for example be provided in another, non-parallel direction, such as for example a diagonal direction, as illustrated in FIG 3.

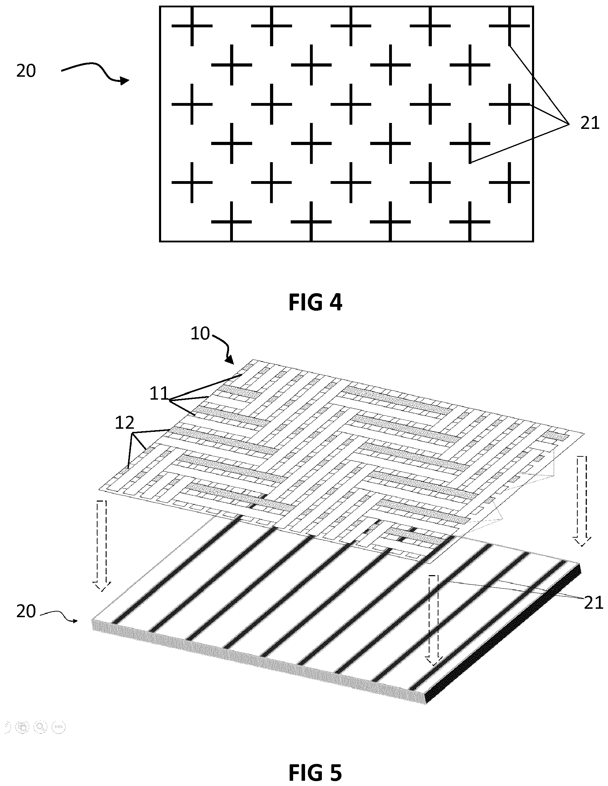

In embodiments of the present invention, the plurality of metal contacts 21 of the photovoltaic cell 20 may have a configuration different from a finger configuration, e.g. different from a configuration consisting of a plurality of substantially parallel metal lines. An example of an alternative metal contact pattern that may advantageously be used is shown in FIG 4. In the context of the present disclosure, it is an advantage of a pattern of metal contacts 21 as shown in FIG 4 that it contains metal features extending in different non-parallel directions. For example, in the example shown in FIG 4, the photovoltaic cell 20 may comprise a plurality of metal contacts 21 that are arranged along substantially orthogonal directions, e.g. forming cross-shaped contacts comprising two elongate contact segments arranged along respectively two perpendicular directions in the plane of the cell, in which, for example, these segments are connected and/or merged to each other at a center point thereof. Such a configuration of the metal contacts 21 may allow a higher flexibility for contacting and/or interconnection, as further described hereinbelow. However, the metal pattern shown in FIG 4 is only one such example, and other suitable metal patterns may be used.

In a method for electrically contacting a photovoltaic cell 20 according to the present disclosure, a woven fabric 10 comprising polymer yarns 11, e.g. polymer wires 11, and electrically conductive wires 12, as described hereinabove, is brought into physical contact with a surface of the photovoltaic cell 20 to which an electrical connection is to be made. This is schematically illustrated in FIG 5 for an example wherein the photovoltaic cell 20 has metal contacts 21 consisting of a plurality of parallel metal fingers. The woven fabric 10 is oriented with a longitudinal direction of the plurality of electrically conductive wires 12 in a direction non-parallel to the longitudinal direction of the plurality of fingers 21. For example, in the example illustrated in FIG 5, the woven fabric 10 is oriented with a longitudinal direction of the plurality of electrically conductive wires 12 in a direction substantially orthogonal to the longitudinal direction of the plurality of fingers 21. However, embodiments of the present invention are not limited thereto and other, non-orthogonal orientations may be used. This may, for example, also be the case when the photovoltaic cell 20 has a plurality of diagonal metal fingers 21 as illustrated in FIG 3.

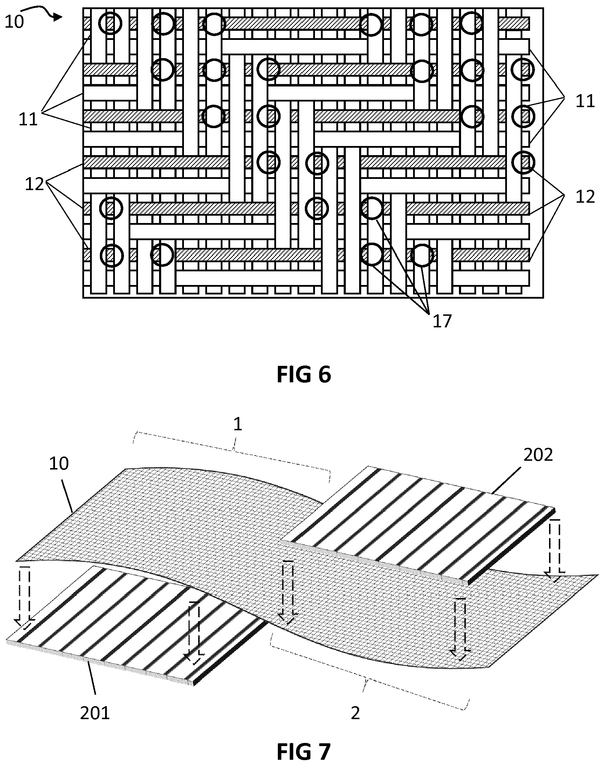

In FIG 6, circles indicate the locations 17 of areas where a contact may be established between an electrically conductive wire 12, e.g. for a fabric 10 as shown in FIG 1, and a metal contact 21 of the photovoltaic cell 20, e.g. for a cell having a finger pattern as shown in FIG 2, after bringing the woven fabric into contact with the photovoltaic cell, e.g. as illustrated in FIG 5. Each metal contact 21 (not shown in FIG 6), may be in contact with more than one electrically conductive wire 12. Each of the plurality of electrically conductive wires 12 may be in contact with a plurality of metal contacts 21, e.g. fingers.

Next, e.g. after the step of bringing the fabric 10 into contact with a surface of the cell 20, a heating process is performed. The heating process may form part of a lamination or encapsulation process of the photovoltaic cell or photovoltaic module. This process may be done in a standard laminator as used in known methods for encapsulating photovoltaic modules. During heating, a pressure may be applied, for example a pressure in the range between 0.8 bar and 1 bar, embodiments of the present invention not being limited thereto.

The heating process may comprise a first heating step at a first temperature and a second heating step at a second temperature. The first temperature, e.g. the temperature to which the structure is heated during the first heating step, may be selected based on the melting temperature of the solder material, e.g. the solder coating of the plurality of electrically conductive wires. The first temperature may, for example, be in the range between 45°C and 400°C, preferably in the range between 120°C and 240°C. During this first heating step, the solder coating on the electrically conductive wires may melt such that solder joints are created with the metal contacts of the cell. In other words, the electrically conductive wires may be soldered to the metal contacts at the locations where the electrically conductive wires are in contact with the metal contacts, e.g. at locations 17 such as indicated by circles in the example shown in FIG 6. This may thus result in electrical connections being established between metal contacts 21 of the photovoltaic cell 20 and electrically conductive wires 12 of the fabric 10. The first temperature is preferably lower than the melting temperature of the material of the polymer yarns. The first temperature is preferably higher than the melting temperature of a solder alloy coating of the electrically conductive wires 12.

After soldering, in a first step of the heating process, the temperature may be raised to a second temperature in a second step of the heating process. The second temperature may be selected based on the melting temperature of the material of the polymer yarns. Preferably the polymer yarns may have a melting temperature that is higher, such as for example 10°C to 50°C higher, than a soldering temperature of the electrically conductive wires 12, e.g. than a melting temperature of a solder alloy coating of the electrically conductive wires 12. As a result of this second heating step, the plurality of polymer wires or yarns may liquefy, e.g. may melt, such as to transform the plurality of polymer yarns into a smooth cell encapsulation layer.

It is an advantage of using such a two-step heating process as described hereinabove that the first heating step, corresponding to the soldering, can be performed at a first temperature that is lower than the melting temperature of the polymer wires. Therefore, during soldering, the polymer material is not yet liquefied and thus the risk of penetration of polymer material between the metal contacts and the metal wires, which could lead to connections with a high electrical resistance, is avoided.

Thus, the heating process may comprise a first heating step at a first temperature to establish the electrical connections and a second heating step at a second temperature, higher than the first temperature, to liquefy the polymer wires, e.g. the polymer yarns, and to form the encapsulation layer.

After having performed the heating process, an encapsulated and contacted photovoltaic cell is obtained, the metal contacts 21 of the cell being electrically connected by electrically conductive wires 12. In operation, an electrical current generated by the photovoltaic cell can be collected at the metal contacts 21 of the cell and it can then be further collected by the electrically conductive wires 12. The electrically conductive wires 12 may thus replace the busbars of photovoltaic cells as known in the art. The electrically conductive wires 12 can be connected to an external lead, e.g. by soldering, for example during the lamination process.

The present disclosure further provides a method for electrically connecting photovoltaic cells, e.g. busbar-free photovoltaic cells, for example as part of a method for fabricating a photovoltaic module.

A method for electrically connecting a first photovoltaic cell 201 with a second photovoltaic cell 202 according to embodiments of the present invention is schematically illustrated in FIG 7, for an embodiment wherein the cells are connected in series. However, embodiments of the present invention are not limited thereto, and the method can also be used for, for example, connecting photovoltaic cells in parallel.

The method comprises providing a woven fabric 10 as described above, e.g. providing a woven fabric as for example illustrated in FIG 1, the woven fabric 10 comprising a plurality of electrically conductive wires 12 provided in a single one of the warp direction and the weft direction, and further comprising a plurality of polymer yarns 11 being provided in at least the other one of the warp direction and the weft direction. The size and shape of the woven fabric 10 may for example be selected to correspond to the size and shape of an area wherein the first and second photovoltaic cells are provided. In embodiments of the present invention, the first photovoltaic cell 201 and the second photovoltaic cell 202 may for example be provided adjacent to each other, with substantially no spacing in between. In such embodiments the size of the woven fabric 10 may be selected to approximately equal twice the size of a photovoltaic cell, e.g. assuming that both cells have the same dimensions. In other embodiments the first and the second photovoltaic cells may be provided with a lateral spacing there in between. In such embodiments the size of the woven fabric 10 is preferably selected to be larger than twice the size of a photovoltaic cell.

In a method of the present disclosure for electrically connecting a first photovoltaic cell 201 with a second photovoltaic cell 202, a first part 1 of the woven fabric 10 is brought into physical contact with a surface of the first photovoltaic cell 201 comprising first metal contacts and a second, e.g. remaining, part 2 of the woven fabric 10 is brought into physical contact with a surface of the second photovoltaic cell 202 comprising second metal contacts. In the example shown in FIG 7, the first part 1 of the woven fabric 10 is brought into contact with a front surface of the first photovoltaic cell 201 and the second part 2 of the woven fabric 10 is brought into contact with a rear surface of the second photovoltaic cell 202 (second metal contacts are not shown in FIG 7) to establish a series connection of the cells. Next a heating process is performed as described above, thereby establishing an electrical connection between the respective first metal contacts and at least one electrically conductive wire of the fabric 10 and between the respective second metal contacts and at least one electrically conductive wire of the fabric 10, and thereby simultaneously transforming the plurality of polymer yarns into an encapsulation layer. At least one, preferably more than one, electrically conductive wire 12 is electrically connected to both a first metal contact and a second metal contact. A plurality of electrically conductive wires may be electrically connected to both a first metal contact and a second contact, for example each electrically conductive wire may be electrically connected to both a first metal contact and a second metal contact.

It is an advantage of a method in accordance with embodiments of the present invention that a series connection of photovoltaic cells can be made without the need for providing a terminal bar as is the case in some prior art solutions. This is because the woven fabric 10 used in a method in accordance with embodiments of the present invention can have metal wires exposed at both opposite surfaces of the fabric, thus enabling electrical connections at both surfaces, i.e. both sides, as illustrated in the example of FIG 7.

Instead of providing a series connection of cells, the first photovoltaic cell 201 and the second photovoltaic cell 202 may for example be electrically connected in parallel. For realizing a parallel connection, a first woven fabric may be brought into contact with the front surface of the first photovoltaic cell and with the front surface of the second photovoltaic cell. A second woven fabric may be brought into contact with the rear side of the first photovoltaic cell and with the rear side of the second photovoltaic cell. This is followed by a heating process as described above.

Furthermore, as for example illustrated in FIG 16 and FIG 17, the woven fabric 10 may have an uneven twill weave. As described in detail hereinabove, the electrically conductive wires 12 may be substantially parallel and oriented in the weft direction x, while the polymer yarns 11 may comprise, e.g. consist of, polymer ribbons, which may be substantially parallel and oriented in the warp direction y (FIG 16). Furthermore, the first part 1 of the woven fabric 10 may be brought into contact with a first photovoltaic cell 201 on a first side of the woven fabric, and the second part 2 of the woven fabric 10 may be brought into contact with a second photovoltaic cell 202 on a second side of the woven fabric, e.g. the first and second side being opposite sides of the woven fabric (FIG 17).

Furthermore, in the first part 1 of the wave fabric 10, a number of polymer yarns 11 over which an electrically conductive wire 12 passes may be larger than the number of yarns 19 under which the electrically conductive wire 12 passes on the first side of the woven fabric, e.g. such as to expose segments of the electrically conductive wire 12 on the first side in the first part of the woven fabric that are longer than segments of the electrically conductive wire 12 covered by the polymer yarns 11, e.g. by polymer ribbons, on the first side in the first part of the woven fabric. Since, in this example, the first side is contacting the first photovoltaic cell 201 in the first part 1 of the fabric, a good area of contact can be provided between the conductive wires 12 and the cell 201.

Likewise, in the second part 2 of the wave fabric 10, a number of polymer yarns 11 over which an electrically conductive wire 12 passes may be larger than the number of yarns 19 under which the electrically conductive wire 12 passes on the second side of the woven fabric, e.g. such as to expose segments of the electrically conductive wire 12 on the second side in the second part of the woven fabric that are longer than segments of the electrically conductive wire 12 covered by the polymer yarns 11, e.g. by polymer ribbons, on the second side in the second part of the woven fabric. Since, in this example, the second side is contacting the second photovoltaic cell 202 in the second part 2 of the fabric, a good area of contact can be provided between the conductive wires 12 and the cell 201.

Thus, the electrical contact between cell and weave can be optimized by combining an uneven warp- and weft-face twill in one weave of the fabric 10, e.g. having a warp-face in the first part 1 and a weft-face in the second part 2. For example, the probability to contact the metal fingers of a photovoltaic cell, e.g. a bifacial solar cell, may improve when the warp-face part of the combined twill weave is covering the top side the cell, whereas the weft-face part of the same weave covers the bottom side of an adjacent photovoltaic cell, e.g. an adjacent bifacial solar cell. For example, the denominator and numerator designating the twill weave, as known in the art to identify twill weaves and described further hereinabove, in the first part may correspond respectively to the numerator and the denominator designating the twill weave in the second part, or, otherwise said, the denominator and numerator may be exchanged, e.g. switched over, between the first part and the second part. For example, as illustrated in FIG 18, the first and second photovoltaic cells 201,202 may be bifacial photovoltaic cells, e.g. having a plurality of metal contacts 21 in the form of contact fingers diagonally oriented, e.g. at 45°. In this example, the first part 1 of the woven fabric may be provided as a 3/1 warp-face twill, while the second part 2 of the woven fabric may be provided as a 1/3 weft-face twill.

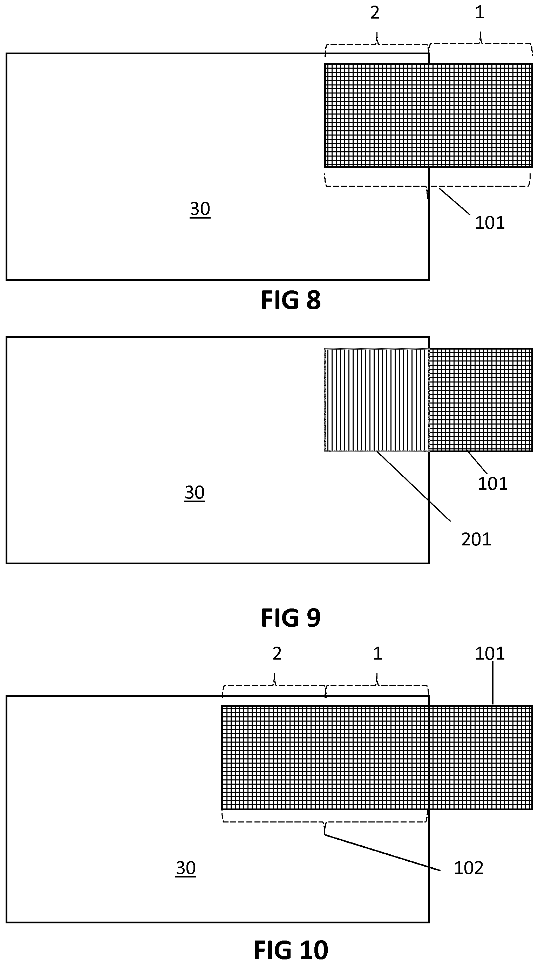

A method in accordance with embodiments of the present invention may be used for fabricating a photovoltaic module comprising a plurality of photovoltaic cells. This is schematically illustrated in FIG 8 to FIG 15, for an example where the plurality of photovoltaic cells are electrically connected in series. However, embodiments of the present invention are not limited to the fabrication of photovoltaic modules having serial electrically connected cells, but may also relate to parallel electrically connected photovoltaic cells, or combinations of serial and parallel electrical connections between the photovoltaic cells.

In a method for fabricating a photovoltaic module in accordance with embodiments of the present invention, the photovoltaic cells and the woven fabric may be preferably assembled on a rigid carrier or on a flexible carrier supported by a rigid structure, e.g. on a vacuum chuck. In advantageous embodiments, a transparent carrier such as a glass plate may be used. It is an advantage that such transparent carrier may function as a superstrate in the photovoltaic module. In such embodiments the process of electrically connecting the photovoltaic cells, the process of encapsulation of the cells and the process of providing a superstrate may be combined.

In the example shown in FIG 8 to FIG 15, a carrier 30, e.g. a transparent carrier, such as for example a glass plate, is first provided. In embodiments of the present invention, a layer of encapsulation material may be provided on the carrier, e.g. the glass plate, first (not shown in FIG 8 to FIG 15), but in other embodiments, a carrier, e.g. a glass plate, without a layer of encapsulation material may be used (as illustrated in FIG 8 to FIG 15). As illustrated in FIG 8, a first woven fabric 101, as described hereinabove, is provided on the glass plate 30. The first woven fabric 101 is provided such that a first part 1 of the fabric extends over an edge of the carrier 30, e.g. the glass plate, for example to enable making external connections, and a second part 2 of the fabric overlaps with the carrier 30, e.g. the glass plate. The size and shape of the second part 2 may preferably fit the size and shape of a first photovoltaic cell 201 that is provided in a next step, e.g. as illustrated in FIG 9, on the second part 2 of the woven fabric 10. In the example shown, the first photovoltaic cell 201 is provided with a front side facing the carrier 30, e.g. the glass plate. The first photovoltaic cell 201 may be a busbar-free cell and the first photovoltaic cell 201 may be preferably oriented with respect to the first woven fabric 101 in such a way that a plurality of contact points or contact areas can be established between metal contacts on the front surface of the first photovoltaic cell 201 and electrically conductive wires of the first woven fabric 101. For example, if the metal contacts on the front surface of the first photovoltaic cell 201 consist of a plurality of parallel lines or fingers as illustrated in FIG 2, the photovoltaic cell 201 may be preferably oriented such that a longitudinal direction of the plurality of fingers is substantially orthogonal to a direction of the electrically conductive wires of the first woven fabric 101. If the metal contacts have a pattern as for example illustrated in FIG 3 or in FIG 4, the orientation of the first photovoltaic cell 201 with respect to the woven fabric, or more particularly, with respect to the electrically conductive wires, may be less restricted.

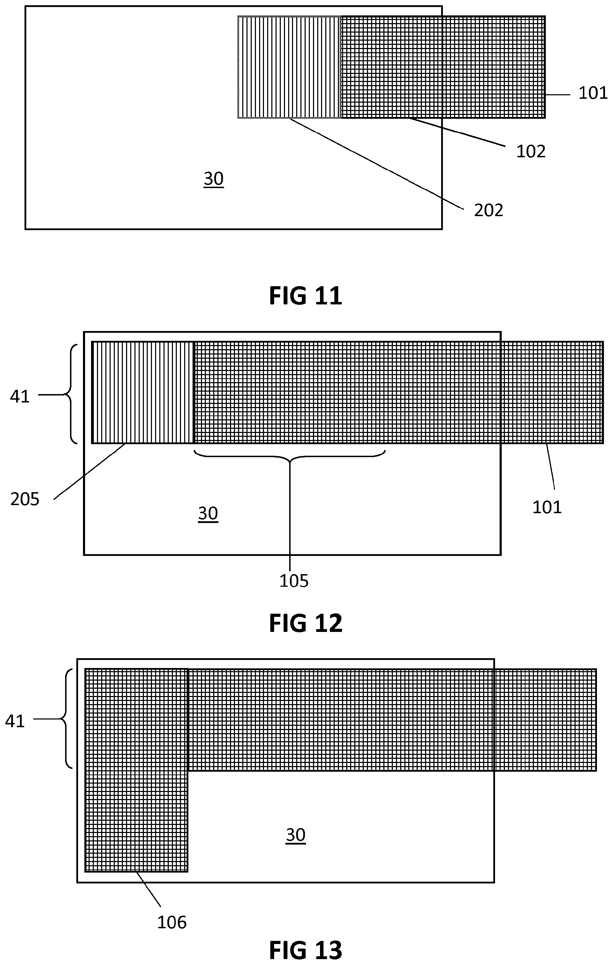

In a next step, illustrated in FIG 10, a second woven fabric 102, as described hereinabove, is provided on the first photovoltaic cell 201 and on the carrier 30, e.g. the glass plate. The second woven fabric 102 is provided such that a first part 1 of the fabric covers the first photovoltaic cell 201, e.g. the rear side of the first photovoltaic cell 201 in the example shown, and a second part 2 of the fabric covers the carrier 30, e.g. the glass plate. The size and shape of the first part 1 may preferably fit the size and shape of the underlying first photovoltaic cell 201. The size and shape of the second part 2 may preferably fit the size and shape of a second photovoltaic cell 202 that is provided in a next step, e.g. as illustrated in FIG 11, on the second part 2 of the second woven fabric 102. The photovoltaic cells may have at their rear side a plurality of solderable metal contacts, such as a plurality of metal fingers, embodiments of the present invention not being limited thereto. The steps illustrated in FIG 10 and FIG 11 may then be repeated, e.g. such that further woven fabrics and photovoltaic cells are provided, until a predetermined length, e.g. a desired length, of a first row or string 41 of cells is obtained. This is schematically illustrated in FIG 12. In embodiments of the present invention, the positioning of the photovoltaic cells and of the fabrics may be done at a temperature higher than ambient temperature, for example at a temperature in the range between 60°C and 80°C. It is an advantage that in this temperature range the polymer wires become slightly sticky, resulting a temporary fixing of the cells and fabrics on the carrier 30.

The first row 41 of photovoltaic cells may be further connected to another, second row of photovoltaic cells. This may be done as for example illustrated in FIG 13, by providing a further woven fabric 106, wherein a first part of the further woven fabric 106 covers the last photovoltaic cell 205 of the first row 41 and wherein a second part of the further woven fabric 106 extends in a direction substantially orthogonal to a longitudinal direction of the first row 41. The woven fabric 106 is thus oriented substantially orthogonal to the orientation of the woven fabrics 101,102,...,105 provided in the first row 41. Next, FIG 14, a further photovoltaic cell 206 is positioned on the second part of the further woven fabric 106. This further photovoltaic cell 206 may thus be the first cell of a second row 42 of cells. In embodiments wherein the further photovoltaic cell 206 has on its front side (which is in contact with the second part of the further woven fabric) metal contacts consisting of a plurality of parallel fingers, such as for example illustrated in FIG 2, the further photovoltaic cell 206 may be preferably turned over 90 degrees (in the plane of the cell) as compared to the photovoltaic cells in the first row 41, to allow good contacting between the front side of the further photovoltaic cell 206 and the further woven fabric 106. In embodiments wherein the further photovoltaic cell 206 has on its front side metal contacts that have features allowing orthogonal or bidirectional contacting, such as for example illustrated in FIG 3 and FIG 4, there may be no need for turning the further photovoltaic cell 206 as compared to the photovoltaic cells of the first row 41. The second row 42 can then be completed in a similar way as the first row 41. The resulting structure, with a first row 41 of photovoltaic cells connected to a second row 42 of photovoltaic cells is schematically shown in FIG 15.

The process can be repeated to connect additional rows of photovoltaic cells, e.g. till a complete module is obtained. Next a heating process is performed, as described hereinabove. During the heating process, electrical connections are established between metal contacts of the photovoltaic cells and electrically conductive wires of the fabrics, and the polymer yarns liquefy and form an encapsulation layer. In embodiments wherein an encapsulation layer is provided on the carrier, e.g. glass carrier, before providing the cells and fabrics, the polymer yarns may liquefy and dissolve in the encapsulation layer, which preferably may comprise the same or a similar material. In embodiments wherein a carrier, e.g. glass carrier, without a layer of encapsulation material is used, a sufficient amount of polymer material may preferably be provided in the fabric to fully encapsulate the cells and to avoid the need for providing additional encapsulation material.

Furthermore, the method may comprise providing a diode 25 at an interconnection between two photovoltaic cells, e.g. between a last photovoltaic cell of a row, e.g. the first row 41, and a first photovoltaic cell of the following row, e.g. the second row 42. Thus, a diode may be provided on and/or in a border region of a woven fabric, e.g. at or near an edge of the woven fabric. For example, a diode may be provided in an overlap region where two edges of respectively two adjacent woven fabrics overlap. The diode may thus be provide to connect two adjacent photovoltaic cell strings.

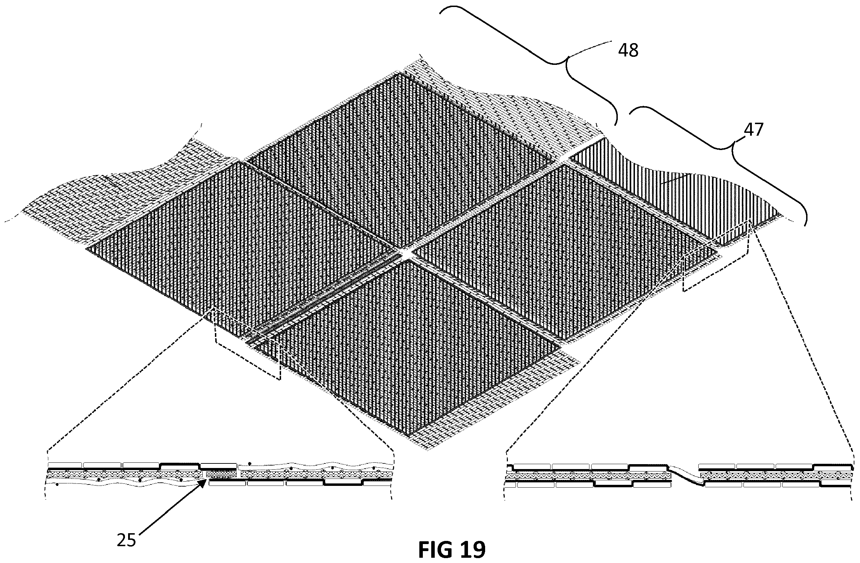

For example, the diode may comprise a silicon n-p junction diode. The diode may have a length equal to the length of photovoltaic cell, e.g. about equal to the width of a photovoltaic cell in the direction along which a single row, or each row, is laid out. The diode may have a width that allows integration of the diode in a space between two adjacent photovoltaic cells, e.g. between two adjacent cell string rows 47, 48 in a module, as shown in FIG 19. For example, the diode may have a width of less than 5 mm, e.g. of 2 mm, e.g. of 1 mm, or even less. The diode may be provided by diode build-up and/or processing methods known in the art. For example, the diode may comprise silver (e.g. deposited using printing technology), aluminum (e.g. provided as a paste), silicon nitride, silicon oxide and/or photovoltaic-grade silicon material. The diode may be contactable at both terminals via respectively the bottom and top side of the two adjacent woven fabrics, e.g. via contact pads, such as silver contact pads, connected, e.g. soldered, to the electrically conductive wires of each of the adjacent woven fabrics.

It is an advantage of a method for fabricating a photovoltaic module according to embodiments of the present invention that there is no need for providing an end ribbon at the end of a row or string of photovoltaic cells.

Advantageously, a good transparency of the woven fabric can for example be used to provide double-glass building integrated photovoltaic modules with large spacing between neighboring cells. A transparent nature of the insulating yarns may also allow the use of bifacial cells.

In a further aspect, the present invention also relates to a photovoltaic module comprising at least two photovoltaic cells, in which the at least two photovoltaic cells are electrically contacted and electrically connected by means of a plurality of electrically conductive wires. The photovoltaic module may be free of terminal bars and free of end ribbons. The photovoltaic module may be fabricated by a method in accordance with embodiments of the present invention. The at least two photovoltaic cells may be busbar-free photovoltaic cells. The at least two photovoltaic cells may be electrically connected in series. Further features of a photovoltaic module in accordance with embodiments of the present invention will be clearly understood by the skilled person from the description provided hereinabove relating to methods in accordance with embodiments of the present invention.

The foregoing description details certain embodiments of the disclosure. It will be appreciated, however, that no matter how detailed the foregoing appears in text, the invention may be practiced in many ways. It should be noted that the use of particular terminology when describing certain features or aspects of the invention should not be taken to imply that the terminology is being re-defined herein to be restricted to including any specific characteristics of the features or aspects of the invention with which that terminology is associated.

While the above detailed description has shown, described, and pointed out novel features of the invention as applied to various embodiments, it will be understood that various omissions, substitutions, and changes in the form and details of the device or process illustrated may be made by those skilled in the technology without departing from the invention.

## Claims

1. A method for electrically contacting a photovoltaic cell (20), the method comprising:
providing a woven fabric (10) comprising a plurality of electrically conductive wires (12), the electrically conductive wires (12) being provided in a single one of a warp direction and a weft direction, the woven fabric (10) further comprising a plurality of polymer yarns (11), the polymer yarns (11) being provided in at least the other one of the warp direction and the weft direction;
bringing the woven fabric (10) into physical contact with a surface of the photovoltaic cell (20) comprising a plurality of metal contacts (21); and
performing a heating process, thereby establishing an electrical connection between the respective metal contacts (21) and at least one electrically conductive wire (12) and thereby liquefying the plurality of polymer yarns (11) and transforming them into an encapsulation layer.

2. The method according to claim 1 wherein the photovoltaic cell (20) is a busbar-free cell.

3. The method according to any of the previous claims, wherein the plurality of metal contacts (21) consist of a plurality of parallel metal lines having a longitudinal direction and wherein bringing the woven fabric (10) in physical contact with the surface of the photovoltaic cell (20) comprises orienting the woven fabric (10) whereby the electrically conductive wires (12) are in a direction different from the longitudinal direction of the parallel metal lines.

4. The method according to claim 1 or claim 2, wherein the plurality of metal contacts (21) are composed of metal features extending in different non-parallel directions.

5. The method according to any of the previous claims, wherein providing the woven fabric (10) comprises providing a twill weave fabric.

6. The method according to any of the previous claims, wherein said polymer yarns (11) comprise polymer ribbons.

7. The method according to claim 6, wherein said polymer ribbons are provided in said warp direction, and wherein said electrically conductive wires (12) are provided in said weft direction.

8. The method according to any of the previous claims, wherein performing the heating process comprises performing a first heating step at a first temperature and thereafter performing a second heating step at a second temperature, the second temperature being higher than the first temperature.

9. A method for electrically connecting a first photovoltaic cell (201) with a second photovoltaic cell (202), the method comprising:
electrically contacting a first photovoltaic cell (201) comprising a plurality of first metal contacts on a surface, using a method according to any of claims 1 to 8; and
electrically contacting a second photovoltaic cell (202) comprising a plurality of second metal contacts on a surface, using a method according to any of claims 1 to 8,
wherein a single woven fabric (10) is used, a first part (1) of the woven fabric (10) contacting the first photovoltaic cell (201) and a second part (2) of the woven fabric (10) contacting the second photovoltaic cell (202), and wherein at least one electrically conductive wire (12) of the woven fabric (10) is electrically connected to both a first metal contact and a second metal contact.

10. The method according to claim 9, wherein the surface of the first photovoltaic cell (201) comprising first metal contacts is a front surface of the first photovoltaic cell and wherein the surface of the second photovoltaic cell (202) comprising second metal contacts is a rear surface of the second photovoltaic cell.

11. The method according to claim 9 or claim 10, wherein said first part (1) is brought into contact with said first photovoltaic cell (201) on a first side of the woven fabric, and said second part (2) is brought into contact with said second photovoltaic cell (202) on a second side of the woven fabric, the first and second side being opposite sides of the woven fabric.

12. The method according to any of claims 9 to 11, wherein said single woven fabric (10) is a twill weave fabric, said first part (1) having an uneven warp-face twill weave, and said second part (2) having an uneven weft-face twill weave.

13. A method for fabricating a photovoltaic module comprising a plurality of photovoltaic cells, the method comprising electrically connecting the plurality of photovoltaic cells using a method according to any of claims 9 to 12.

## Patentansprüche

1. Verfahren zum elektrischen Inkontaktbringen einer Photovoltaikzelle (20), wobei das Verfahren umfasst:
Bereitstellen eines Gewebes (10), das eine Vielzahl von elektrisch leitfähigen Drähten (12) umfasst, wobei die elektrisch leitfähigen Drähte (12) in einer einzigen von einer Kettrichtung und einer Schussrichtung bereitgestellt sind, wobei das Gewebe (10) weiter eine Vielzahl von Polymergarnen (11) umfasst, wobei die Polymergarne (11) in mindestens der anderen von der Kettrichtung und der Schussrichtung bereitgestellt sind;
Bringen des Gewebes (10) in physischen Kontakt mit einer Oberfläche der Photovoltaikzelle (20), die eine Vielzahl von Metallkontakten (21) umfasst; und
Durchführen eines Erwärmungsprozesses, wodurch eine elektrische Verbindung zwischen den jeweiligen Metallkontakten (21) und mindestens einem elektrisch leitenden Draht (12) hergestellt wird und dadurch die Vielzahl von Polymergarnen (11) verflüssigt und in eine Einkapselungsschicht umgewandelt wird.

2. Verfahren nach Anspruch 1, wobei die Photovoltaikzelle (20) eine sammelschienenfreie Zelle ist.

3. Verfahren nach einem der vorstehenden Ansprüche, wobei die Vielzahl von Metallkontakten (21) aus einer Vielzahl von parallelen Metalllinien besteht, die eine Längsrichtung aufweisen, und wobei das Bringen des Gewebes (10) in physischen Kontakt mit der Oberfläche der Photovoltaikzelle (20) ein Ausrichten des Gewebes (10) umfasst, wodurch die elektrisch leitenden Drähte (12) in einer Richtung liegen, die sich von der Längsrichtung der parallelen Metalllinien unterscheidet.

4. Verfahren nach Anspruch 1 oder Anspruch 2, wobei die Vielzahl von Metallkontakten (21) aus Metallelementen zusammengesetzt ist, die sich in verschiedene nichtparallele Richtungen erstrecken.

5. Verfahren nach einem der vorstehenden Ansprüche, wobei das Bereitstellen des Gewebes (10) ein Bereitstellen eines Gewebes mit Köperbindung umfasst.

6. Verfahren nach einem der vorstehenden Ansprüche, wobei die Polymergarne (11) Polymerbänder umfassen.

7. Verfahren nach Anspruch 6, wobei die Polymerbänder in der Kettrichtung bereitgestellt sind und die elektrisch leitenden Drähte (12) in der Schussrichtung bereitgestellt sind.

8. Verfahren nach einem der vorstehenden Ansprüche, wobei das Durchführen des Erwärmungsprozesses ein Durchführen eines ersten Erwärmungsschritts bei einer ersten Temperatur und danach das Durchführen eines zweiten Erwärmungsschritts bei einer zweiten Temperatur umfasst, wobei die zweite Temperatur höher als die erste Temperatur ist.

9. Verfahren zum elektrischen Verbinden einer ersten Photovoltaikzelle (201) mit einer zweiten Photovoltaikzelle (202), wobei das Verfahren umfasst:
elektrisches Inkontaktbringen einer ersten Photovoltaikzelle (201), die eine Vielzahl von ersten Metallkontakten auf einer Oberfläche umfasst, unter Verwendung eines Verfahrens nach einem der Ansprüche 1 bis 8; und
elektrisches Inkontaktbringen einer zweiten Photovoltaikzelle (202), die eine Vielzahl von zweiten Metallkontakten auf einer Oberfläche umfasst, unter Verwendung eines Verfahrens nach einem der Ansprüche 1 bis 8,
wobei ein einzelnes Gewebe (10) verwendet wird, wobei ein erster Teil (1) des Gewebes (10) die erste Photovoltaikzelle (201) und ein zweiter Teil (2) des Gewebes (10) die zweite Photovoltaikzelle (202) kontaktiert, und wobei mindestens ein elektrisch leitender Draht (12) des Gewebes (10) sowohl mit einem ersten Metallkontakt als auch mit einem zweiten Metallkontakt elektrisch verbunden ist.

10. Verfahren nach Anspruch 9, wobei die Oberfläche der ersten Photovoltaikzelle (201), die erste Metallkontakte umfasst, eine Vorderfläche der ersten Photovoltaikzelle ist und wobei die Oberfläche der zweiten Photovoltaikzelle (202), die zweite Metallkontakte umfasst, eine Rückfläche der zweiten Photovoltaikzelle ist.

11. Verfahren nach Anspruch 9 oder Anspruch 10, wobei der erste Teil (1) mit der ersten Photovoltaikzelle (201) auf einer ersten Seite des Gewebes in Kontakt gebracht wird und der zweite Teil (2) mit der zweiten Photovoltaikzelle (202) auf einer zweiten Seite des Gewebes in Kontakt gebracht wird, wobei die erste und die zweite Seite gegenüberliegende Seiten des Gewebes sind.

12. Verfahren nach einem der Ansprüche 9 bis 11, wobei das einlagige Gewebe (10) ein Köpergewebe ist, wobei der erste Teil (1) eine ungleichmäßige Kettflächen-Köperbindung und der zweite Teil (2) eine ungleichmäßige Schussflächen-Köperbindung aufweist.

13. Verfahren zur Herstellung eines Photovoltaikmoduls, das eine Vielzahl von Photovoltaikzellen umfasst, wobei das Verfahren das elektrische Verbinden der Vielzahl von Photovoltaikzellen unter Verwendung eines Verfahrens nach einem der Ansprüche 9 bis 12 umfasst.

## Revendications

1. Procédé pour mettre en contact électriquement une cellule photovoltaïque (20), le procédé comprenant les étapes consistant à :
fournir un tissu tissé (10) comprenant une pluralité de fils électriquement conducteurs (12), les fils électriquement conducteurs (12) étant fournis dans une seule parmi une direction de chaîne et une direction de trame, le tissu tissé (10) comprenant en outre une pluralité de fils de polymère (11), les fils de polymère (11) étant fournis dans au moins l'autre parmi la direction de chaîne et la direction de trame ;
amener le tissu tissé (10) en contact physique avec une surface de la cellule photovoltaïque (20) comprenant une pluralité de contacts métalliques (21) ; et
effectuer un processus de chauffage, établissant ainsi une connexion électrique entre les contacts métalliques respectifs (21) et au moins un fil électriquement conducteur (12) et liquéfiant ainsi la pluralité de fils de polymère (11) et les transformer en une couche d'encapsulation.

2. Procédé selon la revendication 1, dans lequel la cellule photovoltaïque (20) est une cellule exempte de barre omnibus.

3. Procédé selon l'une quelconque des revendications précédentes, dans lequel la pluralité de contacts métalliques (21) consiste en une pluralité de lignes métalliques parallèles présentant une direction longitudinale et dans lequel l'étape consistant à amener le tissu tissé (10) en contact physique avec la surface de la cellule photovoltaïque (20) comprend l'étape consistant à orienter le tissu tissé (10) selon lequel les fils électriquement conducteurs (12) sont dans une direction différente de la direction longitudinale des lignes métalliques parallèles.

4. Procédé selon la revendication 1 ou la revendication 2, dans lequel la pluralité de contacts métalliques (21) est composée de caractéristiques métalliques s'étendant dans des directions non parallèles différentes.

5. Procédé selon l'une quelconque des revendications précédentes, dans lequel l'étape consistant à fournir le tissu tissé (10) comprend l'étape consistant à fournir un tissu en tissage en sergé.

6. Procédé selon l'une quelconque des revendications précédentes, dans lequel lesdits fils de polymère (11) comprennent des rubans de polymère.

7. Procédé selon la revendication 6, dans lequel lesdits rubans de polymère sont fournis dans ladite direction de chaîne, et dans lequel lesdits fils électriquement conducteurs (12) sont fournis dans ladite direction de trame.

8. Procédé selon l'une quelconque des revendications précédentes, dans lequel l'étape consistant à effectuer le processus de chauffage comprend l'étape consistant à effectuer une première étape de chauffage à une première température et ensuite effectuer une seconde étape de chauffage à une seconde température, la seconde température étant supérieure à la première température.

9. Procédé pour raccorder électriquement une première cellule photovoltaïque (201) avec une seconde cellule photovoltaïque (202), le procédé comprenant les étapes consistant à :
mettre en contact électriquement une première cellule photovoltaïque (201) comprenant une pluralité de premiers contacts métalliques sur une surface, en utilisant un procédé selon l'une quelconque des revendications 1 à 8 ; et
mettre en contact électriquement une seconde cellule photovoltaïque (202) comprenant une pluralité de seconds contacts métalliques sur une surface, en utilisant un procédé selon l'une quelconque des revendications 1 à 8,
dans lequel un tissu tissé unique (10) est utilisé, une première partie (1) du tissu tissé (10) entrant en contact avec la première cellule photovoltaïque (201) et une seconde partie (2) du tissu tissé (10) entrant en contact avec la seconde cellule photovoltaïque (202), et dans lequel au moins un fil électriquement conducteur (12) du tissu tissé (10) est raccordé électriquement à la fois à un premier contact métallique et à un second contact métallique.

10. Procédé selon la revendication 9, dans lequel la surface de la première cellule photovoltaïque (201) comprenant des premiers contacts métalliques est une surface avant de la première cellule photovoltaïque et dans lequel la surface de la seconde cellule photovoltaïque (202) comprenant des seconds contacts métalliques est une surface arrière de la seconde cellule photovoltaïque.

11. Procédé selon la revendication 9 ou la revendication 10, dans lequel ladite première partie (1) est amenée en contact avec ladite première cellule photovoltaïque (201) sur un premier côté du tissu tissé, et ladite seconde partie (2) est amenée en contact avec ladite seconde cellule photovoltaïque (202) sur un second côté du tissu tissé, les premier et second côtés étant des côtés opposés du tissu tissé.

12. Procédé selon l'une quelconque des revendications 9 à 11, dans lequel ledit tissu tissé unique (10) est un tissu en tissage en sergé, ladite première partie (1) présentant un tissage en sergé de côté chaîne inégal, et ladite seconde partie (2) présentant un tissage en sergé de côté trame inégal.

13. Procédé pour fabriquer un module photovoltaïque comprenant une pluralité de cellules photovoltaïques, le procédé comprenant l'étape consistant à raccorder électriquement la pluralité de cellules photovoltaïques en utilisant un procédé selon l'une quelconque des revendications 9 à 12.
